(19) Europäisches Patentamt
European Patent Office
Office européen des brevets

(11) Publication number: 0 324 615 A2

(12) EUROPEAN PATENT APPLICATION

(21) Application number: 89300256.8

(22) Date of filing: 12.01.89

(51) Int. Cl.$^4$: G 03 F 7/10

(30) Priority: 15.01.88 US 144525 16.02.88 US 155919 02.11.88 US 266014

(43) Date of publication of application: 19.07.89 Bulletin 89/29

(84) Designated Contracting States: AT BE CH DE ES FR GB GR IT LI NL SE

(71) Applicant: Chien, James C. W.
15 Coach Lane
Amherst Massachusetts (US)

(72) Inventor: Chien, James C. W.
15 Coach Lane
Amherst Massachusetts (US)

(74) Representative: Allsop, John Rowland
Rowland Allsop & Co. Black Boy Yard 15 High Street
West Wycombe High Wycombe, Bucks. HP14 3AE (GB)

# (54) Metal oxide superconducting polymer composites.

(57) A process for producing a pattern of metal oxide superconducting (MOS) pathways, that comprise, combining a resist polymer, including polymers of heteroatom aromatic rings (HRP), with compounds of metals by forming a polymer metal complex precursor (PMC); applying said PMC as a layer to a substrate; irradiating the layer with an image of such pattern as by one or more of visible and invisible electromagnetic waves, electron beam, gamma rays and laser beam irradiation. By proper choice of the energy and intensity of the radiation an image is created directly which is superconducting. Other choices of radiation forms a latent image in either positive or negative modes which is then developed by oxygenating the layer at elevated temperature to transform the same into a MOS of superconducting pathways corresponding to said pattern. Novel superconducting structures particularly useful in semiconductor integrated circuit and LSIC applications can be produced by this process. The novel heteroatom aromatic ring polymers (HRP) are also useful more generally, as is the generic process of producing superconducting composites of a mixture of metal-oxide superconductor (MOS) with a monomer either with or without catalyst or initiator and with subsequent polymerization, or mixing the MOS with a polymer solution and subsequently removing the solvent.



Bundesdruckerei Berlin

## Description

### Metal Oxide Superconducting Polymer Composites

The present invention relates to metal oxide superconductor-polymer composites and methods of preparing the same, including composites in which novel thermally stable highly radiation sensitive resists are employed which, though useful as resists and the like in general, are particularly useful in forming interconnected metal-oxide-polymer superconducting pathways for integrated circuit and similar applications.

A first feature of the invention resides in a process for producing metal oxide superconductor-polymer composites and composites thereby formed, that represent a departure from the usual "ceramic" technology techniques for the preparation of the recently discovered metal oxide superconductors (hereinafter frequently referred to as "MOS") described, for example, in the following journal articles: J.G. Bednorz and K.A. Muller, z., phys. B64, 189 (1986); C.W. Chu, P.H. Hor, R.L. Meng, L. Gao, Z.J. Huang, Y.Q. Wang, J. Bechtold, D. Campbell, M.K. Wu, J. Ashburn, and C.Y. Huang, Phys. Rev. Lett. 58, 405 (1987); P.M. Grant, R.B. Beyers, E.M. Engler, G. Lim, S.S.P. Parkin, M.L. Ramirez, V.Y. Lee, A. Nazzal, J.E. Vazquez, and R.J. Savoy, Phys. B35, 7242 (1987); R.J. Cava, B. Batlogg, R.B. van Dover, D.W. Murphy, S. Sunshine, T. Siegrist, J.P. Remeika, E.A. Rietman, S. Zahurak, and G.P. Espinosa, Phys. Rev. Lett. 58, 1676 (1987).

Examples are compounds of La, Sr, Cu and O, or Y, Ba, Cu and O; Bi, Sr, Ca, Cu; and Tl, Sr, Ca, Cu, prepared by ceramic technology such as grinding the appropriate metal oxides, sesquioxides, carbonates, and nitrates followed by calcining and sintering. In a short span of time, MOS structures with $T_c$ in excess of 90° K have been discovered. However, according to this method, powdery MOS is obtained and there can be little if any control over the morphology, grain size, grain boundary and grain structures, or current density. The MOS powders are usually compressed and sintered or fused into objects. Various metal vapor deposition techniques have been proposed for preparing thin MOS films on a substrate.

In contrast, one of the processes of formation entails mixing the MOS with functional polymer (hereinafter "FP") solution resulting in a polymer-metal-complex precursor (hereinafter "PMC") the FP being one that forms soluble complexes with the metal ions in the MOS. Such was found to enable significant control over the morphology rendering it continuous, and control over grain size, boundary and structure of the resulting superconducting product.

In this novel PMC/MOS technology these precursors are transformed into three standing MOS film or free-standing MOS filaments or other shapes of micron diameters with the extremely important advantage that the MOS grains has naturally interconnected microstructures; ie. the fiber or film is superconducting without the need of fusion of discrete and disconnected grains as by sintering. In addition to the above advantages, the process and product enable the use of lower fabrication temperatures (by 100° C or more than the "ceramic" technique), shorter fabrication time (one-tenth of time of calcination of the "ceramic" technique), shorter annealing time (less than one-tenth of that used in the "ceramic" process), and precise control of grain size of uniform dimension (again in contrast to a broad distribution of grain sizes by the "ceramic" process route), among others.

Many FP polymers had been found to be useful in the PMC/MOS invention, having (I) backbone structures known to depolymerize to monomers or to pyrolyze or oxidize cleanly to volatile products above certain temperatures, and (II) functional groups which can complex chelate metal ions by ionic or polar interactions. Also useful are functional copolymers of two monomers, one of which possess the (I) requirement,or both (I) and (II) requirements. The FP's are obtained by the polymerization of one of two types (a and b) of monomers into FP-a and FP-b functional polymers. The a-type comprises of chain growth monomers selected from the groups that include vinyl esters, acrylates, acrylic acids, aldehydes, cyclic acetals, acrylonitriles, styrenes, lactones and lactams. The b-type comprises of step growth monomers selected from the groups that include diamines, diols, dianhydride, dicarboxylic acids and di-sulfocarboxyanhydrides. Both FP-a and FP-b contain complexation functionalities either in the pendant group or in the backbone. The metal elements include those of groups 1b, 2a, 3a,3b, and 5a of the Periodic Table. One common characteristic of polymers is the ability to form homogeneous and soluble complexes with desired ions in the appropriate ratio. Three different metal ions are usually contained in the metal polymer complex of this invention such as La, Sr and Cu. Another set of metal ions for the precursor synthesis are Y, Ba and Cu. Other sets of metal ions, including those earlier referenced, can be used. The invention is applicable to other metal oxide systems when they are discovered.

The ratio of the number of metal ions per polymer chain is varied to control the rates of nucleation, of grain growth, and of the morphology desired for the physical, mechanical and electrical properties of the MOS. The concentration of the metal polymer composite is adjusted so that the solution has a viscosity suitable for fiber spinning or film casting. After calcination, the fiber or film produced has the frit texture with the same $T_c$ and X-ray diffraction patterns published for the particular MOS.

The criteria for the choice of the FP to form the metal polymer complex are that the polymer be of sufficient molecular weight, i.e., greater than about 10,000, so that its solution has adequate viscosity for spinning and casting into physically strong fibers and films, respectively; and that the FP and the set of metal compounds will co-dissolve in a common solvent to form a clear homogeneous solution. That molecular complexes or chelates are formed between the FP and the metal ions is indicated by the clarity and transparency of the fiber or film obtained after solvent evaporation, indicating the absence of precipitated metal compounds or other separation into two or more phases. The functional polymer, moreover, should be of the type which

thermolyzes cleanly its constituent monomer, or otherwise pyrotyze or oxidize into volatile fragments. The last criterion is met by substances such as chain growth polymers and copolymers of methacrylic acid, acrylic acid, atropic acid, citraconic acid, methylene malonic acid, α methyl styrene sulfonic acid, ε-caprolactam and acrylinitriles or aldehydes, cyclic ethers, and cyclic acetals having said metal complexing or chelating functional substituents, and step growth polymers and copolymers of ester, amide, in the imide, amic acid, imidazole, oxazole and other HRP's capable of metal complexation to form PMC precursors.

The metal compounds should be in the correct stoichiometry for the preparation of the metal polymer complex. For instance, the ratios of the yittrium, barium and copper compounds should be 1:2:3 for the preparation of $Y_1Ba_2Cu_3OX$ MOS, where x is close to seven. The amounts of the metal compounds to be complexed with the polymeric carrier may be varied broadly as a way to control the rate of nucleation of the MOS and consequently the grain size, morphology, gross density, and number of surface functional groups. Further controls are possible through the usage of appropriate rates, durations, and the final temperatures of the pyrolysis with the presence of nucleating agent or growth regulating agent, the oxidative calcination and the annealing processes.

The MOS is endowed with hydroxyl surface groups of between 0.1 to 10 micromoles per gram of MOS. They could contribute to the long term instability of the material. The groups can be functionalized for passivation and improved adhesion.

Some examples follow:

## EXAMPLE 1

Purified acrylic acid (40g), methyl methacrylate (10g) and azo-bis (isobutyronitrile) (0.5g) was polymerized at 60° C for two hours. While fibrous acrylic acid-methylmethacrylic copolymer (35g) was precipitated with 200 ml of methanol and 2 liters of acetone; it was dried overnight at 80° C. Poly(acrylic acid-co-methyl methacrylate) (9.72g) ipthium nitrate pentahydrate (3.65g), barium iodide dihydrate (8.54g) and copper nitrate trihydrate (7.25g) were co-dissolved in dimethyl formamide (100 ml). The solution was cast on glass plate and solvent evaporated to form a precursor film.

The precursor film was heated in an alumina boat at 400° C for two hours under a flowing stream of nitrogen followed by heating at 950° under oxygen for twelve hours and slow cooling over five hours to ambient temperature. The resulting free-standing fritted film has physical integrity and mechanical strength and is superconducting without further treatments such as pelletization under pressure or pulverizing and pelletization. The MOS materials is characterized by linear decrease of resistivity with decreasing temperature above $T_c$ of 95K and very sharp transition of about 1K at $T_c$.

## EXAMPLE 2

Purified poly(methyl methacrylate) (100g) was dissolved in 500 ml of dimethylacetamide and aqueous NaOH added. The hydrolysis was performed at room temperature for two hours. After neutralization with aqueous HCl, washing and drying, 80g of polymer was isolated. Analysis showed the material to contain 75% of methacrylic acid units and 25% of methyl methacrylate units. This copolymer was used to prepare metal complex and conversion to MOS as in Example 1.

## EXAMPLE 3

Purified methacrylic acid (50g) and azo-bis-(isobutyrolnitrile) (0.5g) was polymerized at 60° C for two hours. White fibrous poly (methacrylic acid) (35g) was precipitated with 200 ml of methanol and 2 liters of acetone; it was dried overnight at 80° C. This polymer was used to prepare metal complex which is transformed into MOS as described in Example 1.

## EXAMPLE 4

The metal polymer complex solution of Examples 1 to 3 was used as the spinning solution. After defoaming, the solution was extruded from a spinning nozzle of 100 micron diameter. The extrudate was allowed to pass vertically through an oven kept at 150°C and wound at 10 meter/minute in air. The precursor fiber thus obtained was transparent and had a diameter of 30 micron. It was converted to MOS fritted fiber possessing superconducting properties as given in Example 1.

The FP-b polymers found to be superior in forming the PMC precursors for the MOS include poly (amic acid) prepared by the condensation polymerization of aromatic dianhydrides and aromatic diamines--the PMC presursor being obtained by codissolving the poly (amic acid) and, for example, metal nitrate compounds of Y, Ba and Cu.

Such FP-b polymers, however, have also been used by me in other ways for the very different problem of

producing thermally stable heteratom resist polymers (referred to as "HRP") that are radiation sensitive for microelectronic lithography to manufacture large-scale integrated circuitry (LSIC) devices and other purposes such as passivation of LSIC, this being a second feature of the invention residing in a thermally stable highly sensitive resists and the like. For such purposes, two general classes of polymers have been used for the very different and non-analagous functions of either photo resist (visible or ultraviolet light radiation) or E-beam resist (electron beam, x-ray or other high energy electromagnetic radiation). For positive imaging, the polymer degrades or depolymerizes upon irradiation; whereas for negative imaging, the polymer becomes insolubilized due to cross-linking or other structural changes when exposed to radiation. Certain polymers of exceedingly high thermal stability can be used to produce submicron resolution images.

Prior resist materials suffered from any one of several disadvantages: (a) low $T_g$ (glass transition temperature) limiting prebaking and postbaking conditions; (b) weak mechanical strength or adhesion to resist leading to the formation of line or pin-hole defects; (c) degration by plasma in the process of dry etching. The resists of the invention of this second feature usually do not exhibit glass transitions even at the ver high decomposition temperatures and they are soluble incommon organic solvents, which is essential for spin coating to form micron thick films, but they can form thicker films of, say, forty or more microns. The films thus formed are mechanically strong and adhere strongly to a substrate. These novel resist polymers have been shown to be unusually stable in the environment of plasma typically employed for dry etching to remove the metal oxides surface layer of a substrate.

This process for forming a polymer (and the polymer formed thereby) for passivation and resist uses, that is thermally stable at relatively high temperatures in excess of 400°C, but is sensitive to electromagnetic radiation, includes forming a heteroatom ring polymer that includes a chain formed of a large number of aromatic rings. Intervening moieties, (that is, chemical groupings) are introduced between the successive aromatic rings, which destroy and/or delimit the colinear character and the coplanar character typical of the successive aromatic rings, thus rendering the aromatic rings sensitive to structural change by electromagnetic radiation, and soluble in common organic solvents.

The compounds are the step growth polymers of repeating units having the general structure in expression (1):

-Ar-[Z-Ar′-Z]- (1)

Going from left to right the symbols are the following representations: Ar represents

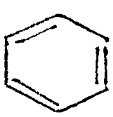

or

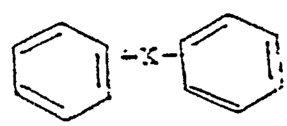

where Z includes

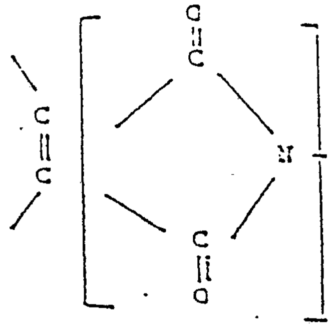

$Z_1$, imide

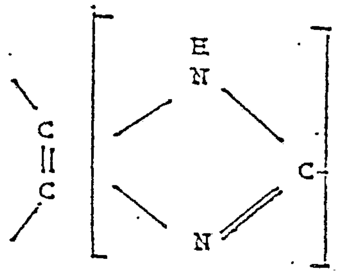

$Z_2$, imidazole

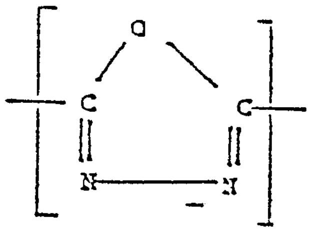

$Z_3$, oxadiazole (3)

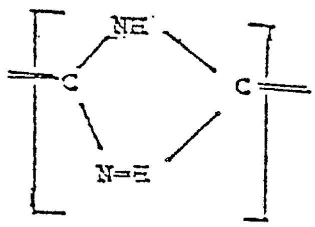

$Z_4$, triazole

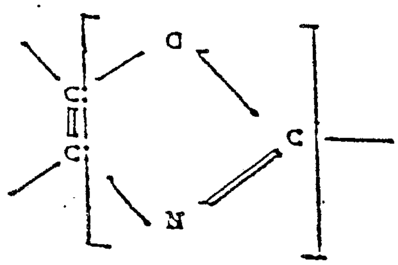

$Z_5$, oxazoles

and Ar' represents

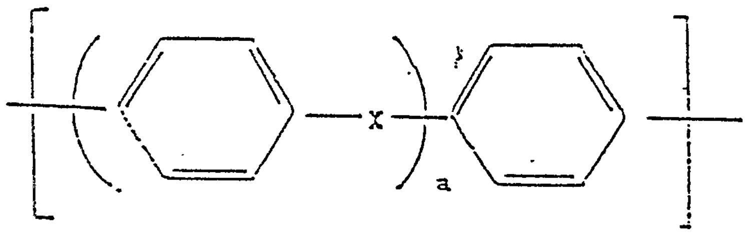

(4)

where a is a small integer between 1 and 3 and the X in Ar′ need not be the same as the X in ar. The moieties τ include

-O-, $-\overset{\text{O}}{\overset{\|}{\text{C}}}-$, -S-, -SO-, $-SO_2-$, and-$C_nF_{2n}$ (n = 1 to 10) and even C-C single bond. By judicious choice of the X group in the moieties Ar and Ar′, the best combination of desirable properties for a resist material can be optimized. The molecular weights of HRP of this invention are those typically obtained by persons practicing the art in the range of 5,000 to 100,000 required for physico-mechanical strengths.

Table I below presents a partial list of the HRP polymers which are active to deep ultraviolet, E-beam and gamma radiation demonstrating the discoveries that some HRP resists act positively and others negatively. The HRP chain, moreover, should contain a certain amount of ring percursor units, such as in Table I, the structural units for Z contain both the imide units II and the amic acid precursor units I. The results given in Table II show the importance of the ring precursor.

Table I. Examples of HRP Resins

| Designation | Structural Units | | | |
|---|---|---|---|---|
| HRP | Ar | | Ar' | Image |
| 1 | 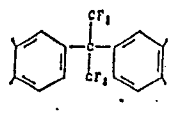 | 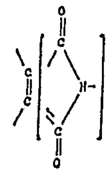 and 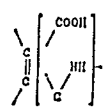 | 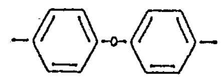 | negative |
| 2 | ditto | ditto | 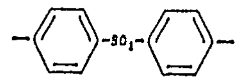 | negative |
| 3 | ditto | ditto | 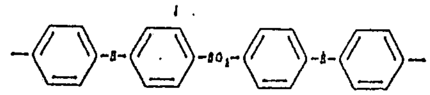 | negative |
| 4 | ditto | ditto | 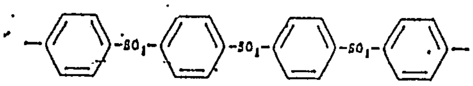 | negative |
| 5 | ditto | ditto | 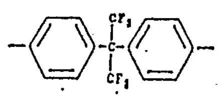 | negative |
| 6 | 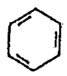 | ditto | 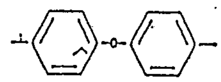 | negative |
| 7 | ditto | ditto | 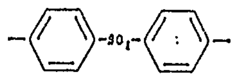 | positive |
| 8 | ditto | ditto | 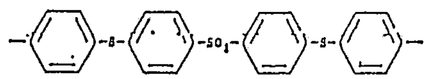 | negative |
| 9 | ditto | ditto | 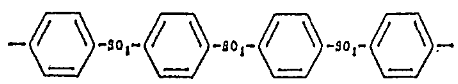 | negative |
| 10 | ditto | ditto | 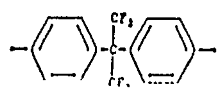 | negative |

Table II.

Effect of Copolymer Content

| HRP | % Imide | Sensitivity ( C cm$^{-2}$) | Resolution | Contrast | Developer (ratio)* |
|---|---|---|---|---|---|
| 7 | 0 - 69 | poor | ---- | ---- | |
| ditto | 87 | 7 | good | 1.9 | 2:1 |
| ditto | 97 | 8 | ditto | 1.0 | 1:0 |
| ditto | 100 | 10 | ditto | 1.7 | 1:0 |
| 1 | 0 | 7.0 | poor | ---- | 1:20 |
| ditto | 62 | 8.0 | good | 0.96 | 1:3 |
| ditto | 81 | 5.0 | good | 0.89 | 1.25 |
| ditto | 90 | 1.5 | excellent | 1.32 | 1.1 |
| ditto | 97 | 2.0 | poor | 1.1 | 1:0.5 |
| ditto | 100 | poor | ---- | ---- | 1:0 |
| 2 | 0 | poor | ---- | ---- | 1:20 |
| ditto | 36 | 10 | poor | ---- | 1:4 |
| ditto | 75 | 5 | good | 1.127 | 1:3 |
| ditto | 92 | 2.5 | excellent | 1.12 | 3:4 |
| ditto | 98 | 3 | excellent | 1.0 | 1:1 |
| ditto | 100 | 2.3 | good | 0.9 | 2:1 |

*The developer is a mxture of DMF and i-propanol the volume ratios of which are given.

The HRP polymers are typically synthesized in two stages. In the first stages the monomeric reactants undergo intermolecular condensation. This is illustrated with pyromellitic dianhydride and phenylene diamine (or p, p′-diameno diphenyl ether).

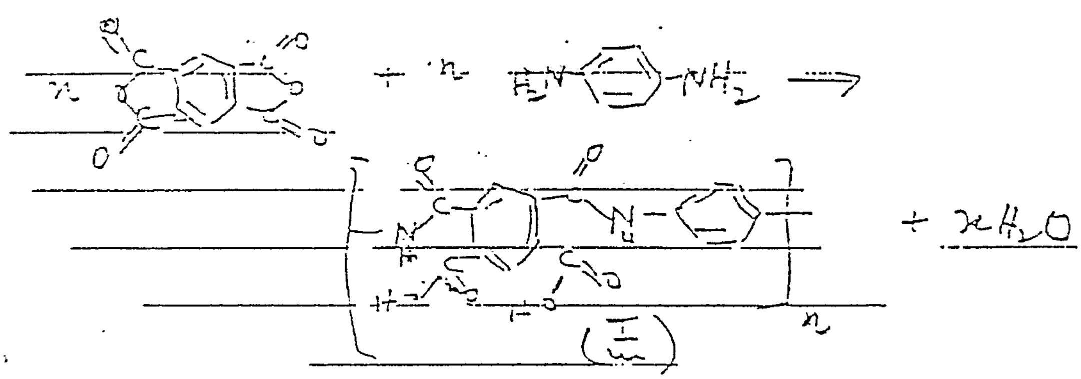

The product is a polyamic acid or sometimes referred to as the A-stage resin. The corresponding B-stage resin which is the polyimide is obtained by complete intramolecular condensation,

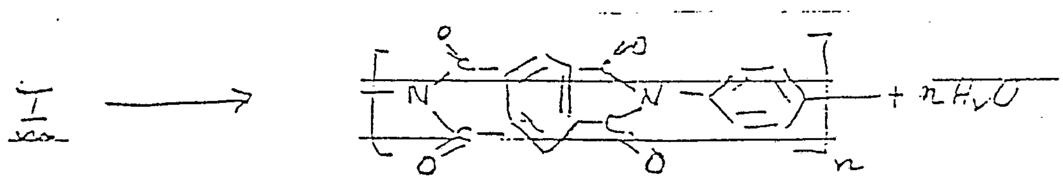

(II)

The same principle applies to other HRP mentioned above.

Underlying the present invention is this novel thermally stable highly sensitive resist, particularly useful with the before described novel metal oxide super-conducting and polymer process (though of other utility as well), and the further realization of the synergism possible stemming from the coincidence of common HRP precursors useful for the resist function of the second-named feature and also for the very different PMC/MOS connected superconducting pathway functions of the first-named feature of invention, above discussed, when used in combination. There resulted the discovery that the combination of the processes of these different concepts could lead to enabling the production of predetermined pattern of superconducting paths in LSIC and similar devices, the superconducting patterns serving as conductors to carry electrical current between active and passive electrical devices formed in the substrate. The HRP is used to prepare the PMC precursors; radiation-induced-images are formed as described in the second-named copending application; and then the PMC precursor is transformed to MOS structures according to the process of the first-named feature of invention application.

This combination opens the door to higher technology MOS applications such as LSIC structures and the like and as connected with bulk power transmission applications, including wires, and other current thrusts as in train levitation and magnet proposals.

The joining of these inventive features is not, however, limited to the FP-b class which corresponds to the HRP in the second-named high temperature resist feature. Other FP-a polymers, useful to form the PMC precursor of the first-named MOS-P feature, as is known to those skilled in the art, may possess resist characteristics as well. Polymers and copolymers of aldehydes and acetals, for example, have been so used as self developing resist. In other words, the PMC precursors prepared with FP-a polymers can be used in place of HPR polymers mentioned above. In particular, the FP-a polymers are usually active as photo resist without or with sensitizing or activating additives.

An object of the present invention, therefore, is to provide a new and improved process for producing metallic-oxide superconducting-resist polymer composites wherein resist polymers are radiation-imaged to develop predetermined patterns and used as the PMC precursor for superconducting pathways suitable for such applications as semiconductor LSIC and the like.

A further object is to provide the highly novel thermally stable (HRP) highly sensitive resists themselves.

Still a further object is to provide the more generic process for producing metal oxide superconducting-polymer composites (MOS-P) and novel composites thereby formed.

Other and further objects will be explained hereinafter and have earlier been discussed, and are more particularly delineated in the appended claims.

In summary, however, from one of its important features, the invention embraces a process for producing a pattern of metal oxide superconducting pathways, that comprises, combining a herteratom aromatic ring polymer resist (HRP), or other resist polymers selected from the FP-a group, with compounds of metals by forming a polymer metal complex precursor (PMC); applying said PMC as a layer to a substrate; irradiating the layer with an image of such pattern as by one or more of visible and invisible electromagnetic waves, electron beam, gamma rays and laser beam irradiation. By proper choice of the energy and intensity of the radiation an image is created directly which is superconducting. Other choices of radiation forms a latent image in either positive or negative modes; and oxygenating the layer at elevated temperature or with an oxygen plasma to transform the same into an MOS of superconducting pathways correspondong to said pattern.

A further feature of the invention is the more generic process of producing a superconducting composite by mixing a metal-oxide superconductor (MOS) with a monomer, with or without catalyst or with or without initiator, and subsequently polymerizing the monomer; or mixing such metal oxide superconductor with a polymer solution and removing solvent; or thermomechanically blending the MOS with a polymer.

Still an additional feature of the invention resides in a novel polymer having a large number of successive aromatic rings with intervening structure that destroy colinear and coplanar structure to render the same sensitive to radiation. Preferred and best mode embodiments and details, including resulting novel structures, are later presented.

In accordance with the present third feature of the invention, accordingly, as exemplarily applied to the important application of forming a predetermined pattern of metal oxide superconducting pathways on an

appropriate substrate, as for semi-conductor integrated circuits and the like (silicon, for example), a thermally stable resist material of the heteroatom aromatic ring polymer (HRP) type or FP-b type polymer is combined with compounds of metals to form a polymer metal complex precursor (PMC) that is applied as a layer of film to an appropriate substrate. The layer is irradiated to form a MOS image directly; or, after developing the latent image of such a pattern, the same is then calcined under oxygen to transform into an MOS. By either procedure there is created superconducting pathways corresponding to designed pattern. As before explained, the resist may operate in either a positive or negative mode.

Proceeding, now, to specific illustrations for the practice of this invention, the following examples demonstrate the process steps underlying the same.

Example 1.

Poly (amic acid) was prepared by the condensation polymerization of pyromellitic dianhydride and p,p′-diaminodiphenyl ether, as before described. The PMC precursor was obtained by co-dissolving the poly(amic acid) and compounds of yttrium, barium and copper in 1:2:3 ratios. The metal compounds to poly(amic acid) ratio are equal amounts in weight. The PMC precursor solution is cast on a MgO substrate and heated to evaporate the solvent. A 20KeV electron beam irradiates the PMC precursor and the same is insolubilized. The latent image is developed by dissolution of the unexposed PMC precursor. The irradiation is carried out in vacuo or under an inert atmosphere, such as nitrogen or argon. The negative image is calcined under oxygen at elevated temperature; (ie. 850°C to 1000°C), so that the insolubilized PMC precursor is transformed to naturally connective MOS. In this example, the HRP acts in the negative resist mode, before discussed.

Example 2.

The insolubilized PMC precursor of Example 1 is converted into interconnected MOS by an oxygen plasma.

Example 3.

Poly(amic acid) was prepared by the condensation polymerization of di(tri fluoromethyl)methylene-bis (phthalic anhydride) and p,p′-diamino diphenyl sulfide. PMC precursor film was cast as in Example 1. Electron beam irradiation will render the PMC precursor more soluble so that it is removed by developer. The unexposed PMC precursor which remained is calcined under oxygen into MOS as in Example 1. In this example the HRP acts in the positive resist mode.

Example 4.

The unexposed PMC precursor of Example 3 is converted to MOS by an oxygen plasma.

Example 5.

Copolymers of methyl methacrylate and methacrylic acid were prepared by copolymerization of the two monomers at 62.5°C initiated by azobis (isobutyronitrile). The PMC precursor was obtained by co-dissolving the copolymer with compounds of yttrium, barium and copper in 1:2:3 ratios. The metal compounds to copolymer ratio are 1:2 in weight. The PMC precursor solution is cast on a MgO substrate and used to form positive superconducting images as in example 3.

Example 6.

PMC precursor films of Examples 1 and 2 are irradiated with laser under an inert atmosphere or in vacuo to effect abrasion of the PMC precursor. The unexposed PMC precursor is converted into MOS by calcination as in Example 1, or by an oxygen plasma as in Example 2.

Example 7.

PMC precursor film is irradiated with electron beam of higher energy and current density than that used in Example 1, such as 100 Kev. Under these conditions, the metal nitrates are converted directly to interconnected MOS by the elimination of nitrogen oxides, such as NO, $NO_2$, $N_2O_5$ etc.

Example 8.

PMC precursor film is irradiated with laser beam of lower intensity than employed in Example 6 (say of the order of 100 MW), but under flowing oxygen. Under these conditions, the PMC precursor is transformed directly into MOS by the radiation.

In connection with Example 7, it will be noted, the high energy electron beam irradiation itself controls the oxygenating transformation of the PMC precursor into MOS by causing breaking up of the oxides of nitrogen. A radiation control of the oxygenating transformation of the PMC precursor into MOS is effected in Example 8 by the lower energy laser beam, under flowing oxygen.

Further modifications will occur to those skilled in this art and such are considered to fall within the spirit and scope of the invention as defined in the appended claims.

## Claims

1. A process for producing a pattern of metal oxide superconducting pathways, that comprises, combining a resist polymer with compounds of metals to form a polymer metal complex precursor (PMC); applying said PMC as a layer to a substrate; irradiating the layer with an image of such pattern as by one or more of visible and invisible electromagnetic waves, electron beam, gamma rays and laser beam irradiation; developing said image in either positive or negative modes; and oxygenating the layer at elevated temperature to transform the same into an MOS of superconducting pathways corresponding to said pattern.

2. A process as claimed in claim 1 in which the resist polymer is a heteroatom aromatic ring polymer resist (HRP).

3. A process as claimed in claim 1 in which the resist polymer is one of FP-a type.

4. A process as claimed in claim 1 and in which oxygenating is effected while calcining the layer.

5. A process as claimed in claim 1 and in which the oxygenating is effected in oxygen plasma.

6. A process as claimed in claim 1 and in which the said metal compounds are selected from the groups consisting of Yt, Ba, Cu; Bi, Sr, Ca, Cu; Tl, Sr, Ca, Cu; and combinations of such elements.

7. A process as claimed in claim 2 and in which said HRP aromatic ring polymer has intervening structures selected from the group consisting of imide, imidazole, oxadizole, triazole and oxazole groups and their corresponding precursor groups.

8. A process as claimed in claim 7 and in which said HRP comprises poly(amic acid).

9. A process as claimed in claim 1 and in which the irradiation insolubilizes the PMC precursor and the developing is in the negative mode and is effected by dissolving the irradiation-unexposed portions of the image, with the negative image calcined under oxygen so that the insolubilized PMC precursor is transformed into naturally connective MOS pathways.

10. A process as claimed in claim 1 and in which the irradiation renders the PMC precursor more soluble such that the developing is in the positive mode, and the unexposed portions of the image which remain are calcined under oxygen to transform into naturally connective MOS pathways.

11. A process as claimed in claim 1 and in which the irradiation is effected by electron beam energy, with the oxygenating transformation of the PMC into the MOS being controlled by the beam.

12. A process as claimed in claim 1 and in which the irradiation is effected by laser beam energy in the presence of flowing oxygen.

13. A layer of a pattern of PMC/MOS superconducting pathways formed by the method of claim 1.

14. A layer of a pattern of PMC/MOS superconducting pathways formed by the method of claim 6.

15. A layer of a pattern of PMC/MOS superconducting pathways formed by the method of claim 7.

16. A process to form integrated circuits on a substrate in which circuit components can be formed, that comprises:
applying to a major surface of the substrate as a thin-layer composite a resist in the form of a polymer-metal-complex (PMC) precursor which includes materials that can be made superconducting and at least one thermally stable heteroatom resist polymer (HRP) intermixed;
irradiating the thin-layer composite to achieve selective removal of portions of the thin-layer composite, whereby many electrical devices can be formed in the substrate; and
processing the polymer-metal-complex (PMC) precursor to convert the precursor to a metal-oxide-superconductor (MOS) to carry electric current between said devices.

17. A process for producing a superconducting composite, that comprises one of,

(a) mixing a metal-oxide superconductor (MOS) with a monomer either with or without a catalyst or with or without an initiator, and subsequently polymerizing the monomer;

(b) mixing a metal-oxide superconductor (MOS) with a polymer solution and subsequently removing the solvent;

(c) thermomechanically blending a metal-oxide superconductor (MOS) with a polymer;

(d) processing a mixture of metal-oxide superconductor (MOS), catalyst and monomer and a second mixture of MOS, cocatalyst and monomer; and

(e) reaction processing a first mixture of MOS, catalyst and monomer and a second mixture of MOS and comonomer with and without catalyst.

18. The process according to claim 17 wherein the composite contains 20 to 80 volume percent of MOS.

19. The process according to claim 17 wherein the MOS comprises metal elements from the groups 2a, 3b and 1b of the Periodic Table.

20. A metal-polymer complex that exhibits superconducting properties, that comprises, a metal oxide superconductor and a polymer or a copolymer intermixed to form a substantially homogeneous complex, said polymer or copolymer being one that forms soluble complexes with metal ions in said metal-oxide superconductor.

21. A metal-polymer complex according to claim 20 in which the metal in said metal-oxide superconductor is taken from the group consisting of groups 2a, 3b and 1b of the Periodic Table.

22. A metal-polymer complex according to claim 21 in which the metal is taken from the group consisting

of La, Sr, Cu, Y and Ba.

23. A metal-polymer complex according to claim 20 in the form of one of a continuous fiber, filament or film or molded object, said metal-oxide superconductor being $Y_1Ba_2Cu_3O_7$.

24. A polymer having a repeating unit of the formula

- Ar - [Z - Ar' - Z] -

wherein Ar is selected from the group consisting of

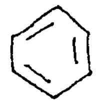

or

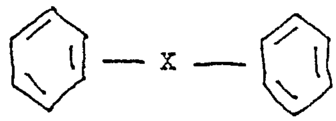

and Ar' represents

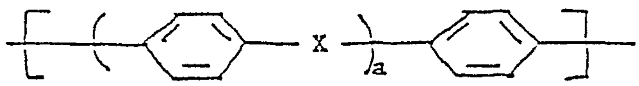

in which each X is individually selected from the group consisting of - O -, - S -, - SO -, $SO_2$ -, - C -, - $C_nF_{2n}$ - and - $C_nF_{2n+1}$, and a is a small integer between one and three, and Z is a group selected from imide, imidazole, oxadiazole, triazole and oxazole groups and their corresponding precursor groups.

25. A material that comprises polymer that comprises a large number of successive aromatic rings with intervening structures that destroy the colinear character and the coplanar character typical of the successive aromatic rings to render the HRP sensitive to and unstable in the presence of radiation used to create integrated electrical circuits, yet stable at temperatures used to create said integrated circuits, and is soluble in common organic solvents.

26. A material according to claim 25 in which the polymer is a heteratom ring polymer, preferably a copolymer containing both partially and completely condensed structure units of imide, imidazole, oxadiazole, triazole and oxazoles groups.

27. A material according to claim 26 wherein the intervening structures are taken from the group consisting essentially of imides, imidazoles, oxadiazoles, triazoles and oxazoles and their precursor groups.

28. A process for forming a polymer for passivation, resist and device bonding applications of semiconductor devices that is thermally stable at relatively high temperatures in excess of 400 degress C. but is sensitive to electromagnetic radiation, that comprises:

forming a heteratom ring polymer that includes a chain formed of a large number of successive aromatic rings; and

introducing intervening moieties between the successive aromatic rings, which moieties destroy and/or delimit the colinear character and the coplanar character typical of the successive aromatic rings, thus rendering the chain of aromatic rings sensitive to structural changes by radiation yet thermally stable at said high temperatures.

29. A mixture of HRP of claim 26.